Europäisches Patentamt

European Patent Office

Office européen des brevets

(19)

(11) Veröffentlichungsnummer: **0 256 426**
**A1**

# (12) EUROPÄISCHE PATENTANMELDUNG

(21) Anmeldenummer: **87111283.5**

(22) Anmeldetag: **04.08.87**

(51) Int. Cl.4: **H03K 17/73**

(30) Priorität: **18.08.86 DE 3627935**

(43) Veröffentlichungstag der Anmeldung:
**24.02.88 Patentblatt 88/08**

(84) Benannte Vertragsstaaten:
**AT CH DE FR GB IT LI SE**

(71) Anmelder: **Siemens Aktiengesellschaft Berlin und München**
**Wittelsbacherplatz 2**
**D-8000 München 2(DE)**

(72) Erfinder: **Peppel, Michael, Dr.**
**Rote Turmstrasse 16**
**D-6940 Weinheim (Bergstrasse)(DE)**

(54) **Vorrichtung zur Aufrechterhaltung des sperrenden Schaltzustandes eines abschaltbaren Thyristors.**

(57) Zur Aufrechterhaltung des stromsperrenden Schaltzustandes eines schaltbaren Thyristors wird im Fehlerfalle, d.h. bei Ausfall der sperrenden negativen Gate-Kathoden-Spannung, ein niederohmiger Nebenschluß zwischen dem Gate-und Kathodenanschluß des Thyristors zugeschaltet. Dieser enthält bevorzugt einen selbstleitenden Feldeffekttransistor, welcher zumindest bei abgeschaltetem Thyristor durch die negative Thyristor-Gate-Kathoden-Spannung selbst bzw. mittelbar durch eine diese Spannung hervorrufende Versorgungsspannung im Sperrzustand gehalten wird. Der Drain-Source-Strecke des Transistors ist eine Diode mit niedriger Durchlaßspannung in Reihe geschaltet, um einen unerwünschten Inversbetrieb des Transistors zu verhindern.

FIG 2

EP 0 256 426 A1

## Vorrichtung zur Aufrechterhaltung des sperrenden Schaltzustandes eines abschaltbaren Thyristors

Die Erfindung bezieht sich auf eine Vorrichtung zur Aufrechterhaltung des den Anoden-Kathodenstrom unterbrechenden Schaltzustandes eines abschaltbaren Thyristors ("GTO-Thyristor") auch bei Ausfall einer diesen Schaltzustand hervorrufenden negativen Steuerspannung zwischen dem Gate-und Kathodenanschluß des Thyristors.

GTO-Thyristors zeichnen sich im Gegensatz zu konventionellen Thyristoren bekanntlich dadurch aus, daß der Anoden-Kathodenstrom durch das Bauelement im normalen Betrieb jederzeit durch das Anlegen einer ausreichend negativen Gate-Kathodenspannung unterbrochen werden kann. Das Bauelement wird hierdurch in den stromsperrenden Schaltzustand gesteuert, ohne daß ein natürlicher Nulldurchgang des Anoden-Kathodenstromes abgewartet werden müßte. Dieser Schaltzustand bleibt im Prinzip erhalten, auch wenn die abschaltende negative Gate-Kathodenspannung zwischenzeitlich verschwindet, also der Gateanschluß "offen" ist. Solange maximal zulässige Werte für die auftretende statische Anoden-Kathodenspannung bzw. für deren Änderungsgeschwindigkeit im Sperrzustand nicht überschritten werden, ist eine unerwünschte "Überkopf-Zündung" des GTO-Thyristors nicht zu befürchten.

Grenzwerte dieser Art unterliegen jedoch u.U. stark temperaturabhängigen und exemplarbedingten Schwankungen. Ferner sind häufig von anderen Schaltungsteilen auf die Anoden-Kathodenstrecke des gesperrten Thyristors einwirkende Überspannungen großer Anstiegsgeschwindigkeit nicht mit Sicherheit auszuschließen. Aus diesen Gründen und wegen der Notwendigkeit einer optimalen Bauelementeausnutzung muß das Sperrverhalten verbessert und dessen Aufrechterhaltung in allen Betriebszuständen sichergestellt werden. Im Normalbereich einer mit GTO-Thyristoren ausgerüsteten Schaltung ist dies auf einfache Weise dadurch zu erreichen, daß die abschaltende negative Gate-Kathodenspannung auch im Sperrzustand eines jeden Thyristors weiterhin auf dessen Steuerstrecke einwirkt. Der im Sperrzustand in die Thyristoranode fließende thermische Sperrstrom, der bei entsprechender statischer - und/oder dynamischer Spannungsbeanspruchung der Anoden-Kathodenstrecke über den sogenannten "Avalanche-Effekt" die Überkopfzündung des Thyristors verursachen kann, wird durch die anliegende negative Gate-Kathodenspannung abgeleitet.

Im Fehlerfall dagegen, d.h. bei Ausfall der den Sperrzustand aufrechterhaltenden negativen Gate-Kathodenspannung bzw. bei Ausfall von Versorgungsspannungen, die diese Steuerspannung mittelbar treiben, besteht erneut die Gefahr der Überkopfzündung. Insbesondere in Stromrichterschaltungen, z.B. bei Wechselrichtern, wird zusätzlich zum verursachenden Ausfall einer oder mehrerer Versorgungsspannungen im Steuerteil hierdurch auch der Leistungsteil durch Kurzschlüsse stark in Mitleidenschaft gezogen werden.

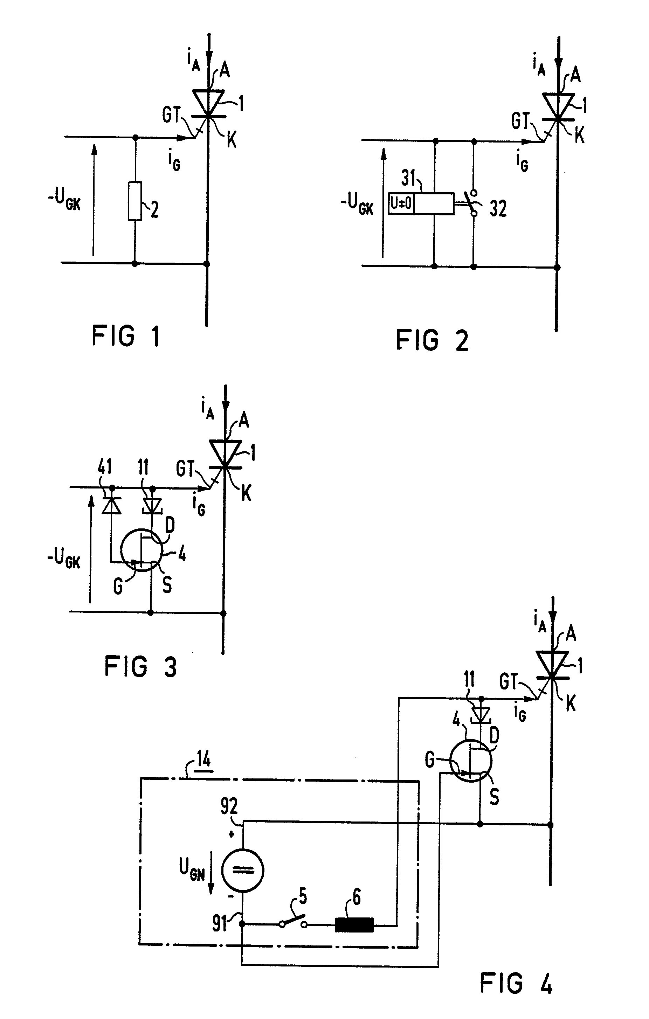

Zur Sicherstellung des Sperrverhaltens von GTO-Thyristoren, insbesondere bei Ausfall der negativen Gate-Kathodensteuerspannung, ist es bereits bekannt, die Gate-Kathodenstrecke mit einem niederohmigen Widerstand zu beschalten. Eine Vorrichtung dieser Art ist in FIG 1 dargestellt. Der dortige Widerstand 2 wirkt als Nebenschluß und leitet den aus dem Gateanschluß GT kommenden thermischen Sperrstrom $-i_G$ an der thyristorinternen npn-Transistorstruktur vorbei direkt an den äußeren Kathodenanschluß K ab.

Ein erheblicher Nachteil dieser Vorrichtung besteht jedoch darin, daß dieser Widerstand insbesondere während der Abschaltung und im gesperrten Zustand des Thyristors aufgrund der anliegenden negativen Gate-Kathodenspannung erhebliche Verlustleistung verursacht. Zudem ist der Nebenschluß umso wirksamer, je niederohmiger er ist. Somit muß erheblich mehr Ansteuerleistung zur Verfügung gestellt werden, was insbesondere bei der Verwendung von Schaltnetzteilen hohe Kosten verursacht. Ferner sind zum Abführen der hierdurch im Steuerkreis auftretenden Wärmemengen zusätzliche Maßnahmen erforderlich.

Der Erfindung liegt folglich die Aufgabe zugrunde, eine Vorrichtung anzugeben, mit deren Hilfe die Sperrfähigkeit des GTO-Thyristors auch im Fehlerfalle, d.h. insbesondere bei Ausfall der negativen Gate-Kathodenspannung, aufrechterhalten werden kann. Der Normalbereich des Thyristors soll hierdurch möglichst wenig beeinträchtigt werden. Insbesondere sollen kaum zusätzliche elektrische Verluste auftreten.

Die Aufgabe wird gelöst durch die Merkmale des Anspruchs 1. Weitere vorteilhafte Ausführungsformen sind in den Unteransprüchen enthalten.

Mit Hilfe der nachfolgend kurz angeführten Figuren 2 bis 7 wird die Erfindung weiter erläutert. Dabei zeigt:

FIG 1 eine bekannte Beschaltung der Thyristor-Gate-Kathodenstrecke,

FIG 2 einen erfindungsgemäßen zuschaltbaren, niederohmigen Nebenschluß für die Thyristor-Gate-Kathodenstrecke,

FIG 3 ein Ausführungsbeispiel der Erfindung mit einem Sperrschichtfeldeffekttransistor als Schaltelement im Nebenschluß,

FIG 4 ein weiteres Ausführungsbeispiel mit einem Treiber zur Abschaltung des Thyristors und zum Ansteuern des Feldeffekttransistors,

FIG 5 ein weiteres Ausführungsbeispiel mit einem MOS-Feldeffekttransistor und einer in Reihe angeordneten Diode im Nebenschluß,

FIG 6 ein weiteres Ausführungsbeispiel mit einem zusätzlichen Spannungsteiler zum Ansteuern des Feldeffekttransistors, und

FIG 7 ein weiteres Ausführungsbeispiel mit einer anderen Anordnung des Spannungsteilers.

In FIG 2 ist ein Prinzipschaltbild der erfindungsgemäßen Vorrichtung dargestellt. Das elektrisch ansteuerbare Schaltelement ist dabei in Form eines elektromechanischen Schalters ausgeführt. Dieser besteht aus einem elektromechanischen Antrieb 31 und einem davon angesteuerten Öffner 32. Der Schalter ist in FIG 2 in betätigter, d.h. geöffneter Stellung abgebildet. Dieser kippt in die Ruhestellung zurück wenn die Gleichspannung $U_{GK}$ beliebigen Vorzeichens am Antrieb 31 verschwindet. Mit dieser Vorrichtung ist es auf einfache Weise bereits möglich, im Fehlerfalle, d.h. bei ausgefallener Thyristor-Gate-Kathodenspannungen, den gewünschten niederohmigen Nebenschluß zuzuschalten.

In elektronischen Schaltungen sind elektromechanische Schaltelemente oft unerwünscht und insbesondere wegen u.U. abweichender Steuerspannungspegel nur mit Aufwand in das vorhandene Schaltungskonzept zu integrieren. Aus diesem Grund ist es besonders vorteilhaft, für das elektrisch ansteuerbare Schaltelement ein elektronisches Bauelement einzusetzten. Hierbei sind wiederum insbesondere Feldeffekttransistoren aufgrund deren nahezu leistungsloser Steuermöglichkeit, der guten Regelmöglichkeit und der niedrigen Verlustleistung, besonders geeignet. Bevorzugt werden hierbei Typen eingesetzt, die bei fehlender Steuerspannung an der Gateelektrode eingeschaltet sind, also "selbstleitende" Eigenschaften haben.

So ist im Ausführungsbeispiel gemäß der FIG 3 ein selbstleitender n-Kanal-Sperrschichtfeldeffekttransistor 4 als elektrisch steuerbares Schaltelement eingesetzt. Falls als Feldeffekttransistor zudem ein asymmetrisch sperrender oder rückwärts leitender Typ verwendet wird, so ist es besonders vorteilhaft, wenn zur Verhinderung eines unerwünschten Inversbetriebes der Drain-Source-Durchlaßstrecke des Transistors zusätzlich eine Diode mit niedriger Durchlaßspannung in Reihe geschaltet wird. In der Schaltung von FIG 3 ist bereits eine solche Diode 11 enthalten, welche eine vom Gate-zum Kathodenanschluß des GTO-Thyristors orientierte Durchlaßrichtung hat. Die Gateelektrode G des Thyristors ist in diesem Ausführungsbeispiel über eine weitere in Durchlaßrichtung angeordnete Diode 41 mit dem Gateanschluß GT des Thyristors 1 verbunden. Der Feldeffekttransistor wird so ausgewählt, daß die im Normalbetrieb auftretende negative Thyristor-Gate-Kathodenspannung die "Abschnürspannung" des Transistors unterschreitet, und dieser somit gesperrt wird. Der Transistor wird erst leitend, wenn entweder die Thyristor-Gate-Kathodenspannung verschwindet oder bei Einschalten des Thyristors positiv wird. Im ersten Fall liegt der betrachtete Fehlerfall vor, in dem der Transistor den niederohmigen Nebenschluß zur Ableitung des thermischen Sperrstromes aufbaut. Aufgrund der Polung der Diode 41 ist der Transistor auch bei positiver Spannung $U_{GK}$ leitend. Da in diesem Fall aber aufgrund der physikalischen Effekte bei der Einschaltung des Thyristors nur eine sehr geringe Thyristor-Gate-Kathodenspannung auftritt, die sich wiederum an dem Transistor als Drain-Source-Spannung abbildet, wird dieser weit im sogenannten "ohmschen Bereich" seines Ausgangskennlinienfeldes betrieben. So bleibt der als Ansteuerverlust auftretende Drain-Strom des Transistors, der dem positiven Steuerstrom $i_G$ in das Gate des Thyristors verloren geht, relativ gering.

Eine weitere vorteilhafte Ausführungsform der erfindungsgemäßen Vorrichtung ist in der FIG 4 dargestellt. Sie enthält einen zusätzlichen Treiber 14 zur Bereitstellung der den Thyristor abschaltenden und den Sperrzustand aufrechterhaltenden negativen Thyristor-Gate-Kathodenspannung $-U_{GK}$. Wesentliches Bestandteil des Treibers ist eine Versorgungsspannungsquelle $U_{GN}$, deren positives Potential am Anschluß 92 mit dem Kathodenanschluß K des Thyristors verbunden ist. Das negative Potential am Anschluß 91 wird über einen Schalter 5 und eine konkret eingebaute bzw. parasitär vorhandene Induktivität 6 im Falle der Abschaltung mit dem Gateanschluß GT des Thyristors 1 verbunden. Es ist nun besonders vorteilhaft, wenn der Steueranschluß G des Thyristors 4 mit dem negativen Potential an der Klemme 91 der Versorgungsspannung verbunden wird. Auf diese Weise ist sichergestellt, daß der Transistor im Normalbetrieb des Thyristors ständig gesperrt und der Nebenschluß somit unwirksam ist. Es treten hierdurch keinerlei zusätzliche Verluste im Normalbetrieb auf.

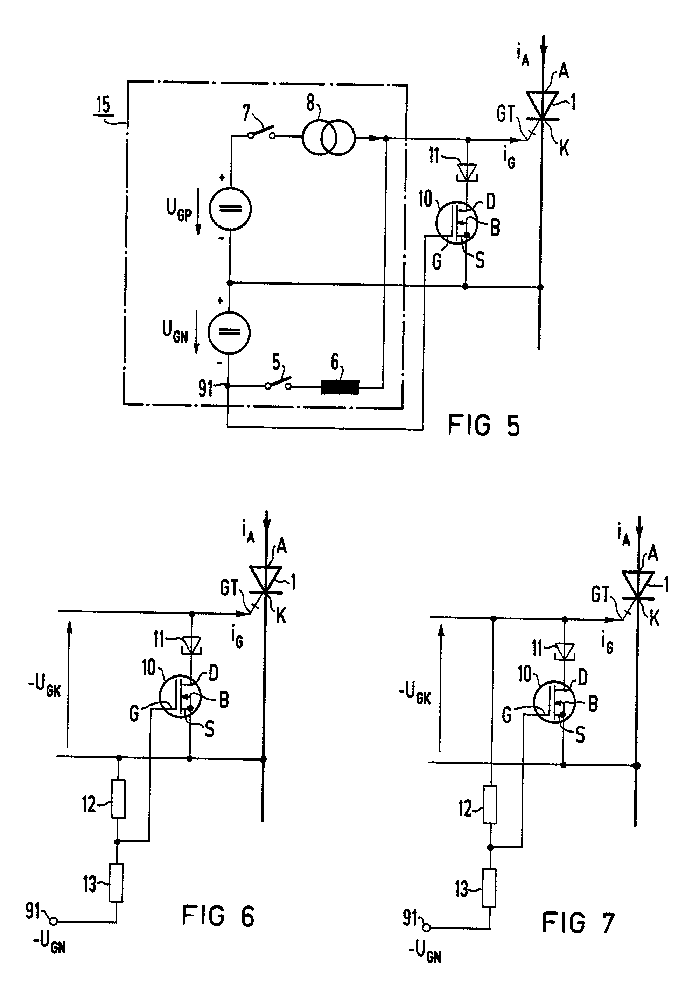

FIG 5 zeigt eine weitere, besonders vorteilhafte Ausführungsform der erfindungsgemäßen Vorrichtung. Als elektrisch steuerbares Schaltelement ist dabei ein selbstleitender n-Kanal-Leistungs-MOS-Feldeffekttransistor 10 verwendet, der kurz als "MOS-FET" bezeichnet wird. Dieser ist aufgrund seiner leistungslosen Ansteuerung und seines niedrigen Drain-Source-Widerstandes besonders geeignet. Bei Feldeffekttransistoren dieser Art ist in der Regel aufgrund deren internen vertikalen Struktur eine sogenannte "Inversdiode" zwischen der Source-und Drain-Elektrode wirksam. Diese - schließt den Transistor bei Umkehrung des Vorzeichens der im Normalbetrieb positiven Drain-Source-Spannung auf der Ausgangsseite kurz. In Wechselrichterschaltungen ist dies u.U. erwünscht, da hierdurch sogenannte "Freilaufdioden" entfallen können. Im vorliegenden Fall dagegen muß dieser Kurzschluß ebenfalls durch eine in Durchlaßrichtung zur Transistor-Drain-Source-Strecke angeordnete Reihendiode 11 verhindert werden, da sonst der Nebenschluß auch bei abgeschaltetem Thyristor wirksam werden würde.

Besonders vorteilhaft sind hierzu Schottky-Diode geeignet. Aufgrund der niedrigen Durchlaßspannung dieses Bauelementes wird die Niederohmigkeit des Nebenschlusses hierdurch kaum beeinträchtigt. Die Ansteuerung des MOS-FET kann dabei in der gleichen Weise wie im Ausführungsbeispiel gemäß FIG 3 durch Anschluß der Gateelektrode über die Diode 41 an den Gateanschluß des Thyristors erfolgen. Ebenso ist die Ansteuerung des MOS-FET entsprechend dem Ausführungsbeispiel gemäß der FIG 4 möglich, wie dies auch in der FIG 5 dargestellt ist. Dort ist der verwendete Treiber 15 zur Ansteuerung des Thyristors beispielhaft um die wesentlichen Schaltelemente erweitert, die für dessen Einschaltung benötigt werden. Dies sind insbesondere eine weitere Versorgungsspannung $U_{GP}$, deren negatives Potential mit dem Thyristor-Kathodenanschluß verbunden ist, ein weiterer Schalter 7 und eine spannungsgesteuerte Stromquelle 8 zur Einprägung des einschaltenden Gatestromes $i_G$.

Zur Anpassung an unterschiedliche Feldeffekttransistortypen, insbesondere mit unterschiedlichen Schwellenspannungen, kann die den Transistor im Normalbetrieb sperrende Versorgungsspannung $U_{GN}$ vorteilhaft über einen Spannungsteiler den Feldeffekttransistordaten angepaßt werden. Dieser besteht entsprechend dem Ausführungsbeispiel gemäß der FIG 6 aus den beiden Widerständen 12 und 13, und ist über den Anschluß 91 am negativen Potential der Versorgungsspannung $U_{GN}$ und am Kathodenanschluß des Thyristors angeschlossen. Das Transistorgate ist zwischen den beiden Widerständen angeschlossen.

In einer weiteren Ausführungsform der Erfindung ist es besonders vorteilhaft, wenn speziell bei einem MOS-FET 10 im Nebenschluß der Spannungsteiler zwischen dem negativen Potential der Versorgungsspannung $U_{GN}$ und dem Gateanschluß GT des Thyristors angeschlossen ist. Dieser Fall ist im Ausführungsbeispiel gemäß der FIG 7 dargestellt. Im Gegensatz zu n-Kanal-Sperrschichtfeldeffekttransistoren liegt die Eingangssteuerkennlinie eines selbstleitenden n-Kanal-MOS-Feldeffekttransistors außer im zweiten auch im ersten Quadranten des $U_{GS}/I_D$ -Kennlinienfeldes. Durch Anlegen einer positiven Gate-Sourcespannung ist es möglich, den Drainstrom und somit die Leitfähigkeit des Transistors weiter zur erhöhen. Da in diesem Fall zwischen dem Anschluß 91 der Spannungsquelle $U_{GN}$ und der Kathode des Thyristors keine Potentialdifferenz besteht, wird durch den über den Spannungsteiler 12, 13 fließenden Teil des thermischen Sperrstromes $-i_G$ eine positive Gate-Sourcespannung an der Steuerstrecke des MOS-FET aufgebaut. Auf diese Weise wird eine "Mitkopplung" des Transistors bewirkt, die den Durchlaßwiderstand des Nebenschlusses weiter reduziert.

Zur weiteren Reduzierung des Durchlaßwiderstandes ist es besonders vorteilhaft, das elektrisch ansteuerbare Schaltelement im Nebenschluß, insbesondere den Feldeffekttransistor, praktisch aus einer Anzahl unmittelbar an den Durchlaßstrecken, d.h. den Drain-Source-Strecken, parallel geschalteter, gleichartiger Schaltelemente auszuführen, die gleichzeitig angesteuert werden.

## Ansprüche

1. Vorrichtung zum Aufrechterhalten des den Anoden-Kathodenstrom unterbrechenden Schaltzustandes eines abschaltbaren Thyristors ("GTO-Thyristor") (1) bei Ausfall einer diesen Schaltzustand im Normalbetrieb hervorrufenden und aufrechterhaltenden negativen Steuerspannung $(-U_{GK})$ zwischen dem Gate-und Kathodenanschluß (GT, K) des Thyristors , **gekennzzeichnet durch**

a) einen zuschaltbaren, niederohmigen Nebenschluß aus einem selbstleitenden n-Kanal-Feldeffekttransistor (4, 10), wobei die Drain-bzw. Sourceelektrode (D, S) des Feldeffekttransistors mit dem Gate-bzw. Kathodenanschluß (GT, K) des abschaltbaren Thyristors verbunden ist, und

b) Mittel (41; 12, 13) welche mit der Gateelektrode (G) des Feldeffekttransistors verbunden sind und den Feldeffekttransistor so ansteuern, daß dieser sich bei Anliegen der negativen Steuerspannung am Thyristor im unterbrechenden Schaltzustand befindet.

2. Vorrichtung nach Anspruch 1 , **gekennzeichnet durch** eine von der Gateelektrode (G) des Feldeffekttransistors zum Gateanschluß (GT) des abschaltbaren Thyristors (1) in Durchlaßrichtung angeordnete Diode (41) als Mittel zum Ansteuern des Feldeffekttransistors (4). (FIG 3)

3. Vorrichtung nach Anspruch 2 , **dadurch gekennzeichnet,** daß der selbstleitende n-Kanal-Feldeffekttransistor ein Leistungs-MOS-Feldeffekttransistor (10) mit interner, von der Source-zur Drainelektrode stromführend wirkender Inversdiode ist, dem eine vom Gate-zum Kathodenanschluß des abschaltbaren Thyristors in Durchlaßrichtung angeordnete weitere Diode (11) mit niedriger Durchlaßspannung in Reihe geschaltet ist.

4. Vorrichtung nach Anspruch 1 mit einem Treiber (14, 15) zum Ansteuern des abschaltbaren Thyristors (1), welcher mindestens eine Versorgungsspannungsquelle ($U_{GN}$) für die negative Steuerspannung (-$U_{GK}$) zum Hervorrufen und Aufrechterhalten des unterbrechenden Schaltzustandes des abschaltbaren Thyristors enthält , **dadurch gekennzeichnet,** daß als Mittel zum Ansteuern des Feldeffekttransistors (4, 10) die Gateelektrode (G) des Feldeffekttransistors mit dem negativen Potential (91) der Versorgungsspannungsquelle verbunden ist. (FIG 4, 5, 6 und 7)

5. Vorrichtung nach Anspruch 4 , **dadurch gekennzeichnet,** daß die Mittel zum Ansteuern des Feldeffekttransistors (4, 10) einen mit dem negativen Potential (91) der Versorgungsspannungsquelle ($U_{GN}$) und dem Kathodenanschluß (K) des abschaltbaren Thyristors (1) verbundenen ohmschen Spannungsteiler (12, 13) enthalten, an dessen Mitte die Gateelektrode (G) des Feldeffekttransistors angeschlossen ist. (FIG 6)

6. Vorrichtung nach einem der Ansprüche 1, 4 oder 5 , **dadurch gekennzeichnet,** daß der selbstleitende n-Kanal-Feldeffekttransistor ein Leistungs-MOS-Feldeffekttransistor (10) mit interner, von der Source-zur Drainelektrode stromführend wirkender Inversdiode ist, dem eine vom Gate-zum Kathodenanschluß des abschaltbaren Thyristors in Durchlaßrichtung angeordnete weitere Diode (11) mit niedriger Durchlaßspannung in Reihe geschaltet ist.

7. Vorrichtung nach Anspruch 5 , **dadurch gekennzeichnet,** daß der selbstleitende n-Kanal-Feldeffekttransistor ein Leistungs-MOS-Feldeffekttransistor (10) mit interner, von der Source-zur Drainelektrode stromführend wirkender Inversdiode ist, dem eine vom Gate-zum Kathodenanschluß des abschaltbaren Thyristors in Durchlaßrichtung angeordnete weitere Diode (1) mit niedriger Durchlaßspannung in Reihe geschaltet ist und daß der ohmsche Spannungsteiler (12, 13) mit dem negativen Potential (91) der Versorgungsspannungsquelle ($U_{GN}$) und dem Gateanschluß (GT) des abschaltbaren Thyristors (1) verbunden ist (FIG 7).

8. Vorrichtung nach einem der Ansprüche 3, 6 oder 7 , **dadurch gekennzeichnet,** daß die weitere Diode (11) in Reihe zum Feldeffekttransistor eine Schottky-Diode ist.

9. Vorrichtung nach einem der vorangegangenen Ansprüche , **dadurch gekennzeichnet,** daß der zuschaltbare, niederohmige Nebenschluß aus mehreren parallel geschalteten Feldeffekttransistoren besteht, deren Gateelektroden miteinander verbunden sind.

FIG 1

FIG 2

FIG 3

FIG 4

FIG 5

FIG 6

FIG 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-3 891 866 (OKUHARA ET AL.) <br> * Insgesamt * <br> --- | 1 | H 03 K 17/73 |
| A | DE-A-3 408 516 (SIEMENS) <br> * Figur 1; Anspruch 1 * <br> --- | 1 | |
| A | DE-A-3 425 414 (SIEMENS) <br> * Figur 1; Zusammenfassung * <br> --- | 1 | |
| A | EP-A-0 106 059 (SIEMENS) <br> * Figur 1; Zusammenfassung * <br> ----- | 1 | |

RECHERCHIERTE SACHGEBIETE (Int. Cl.4)

H 03 K
H 02 H

Der vorliegende Recherchenbericht wurde für alle Patentansprüche erstellt

| Recherchenort | Abschlußdatum der Recherche | Prüfer |
|---|---|---|
| DEN HAAG | 16-11-1987 | KOLBE W.H. |

EPO FORM 1503 03.82 (P0403)